(19) Europäisches Patentamt
European Patent Office
Office européen des brevets

(11) **EP 2 036 996 A1**

(12) **EUROPÄISCHE PATENTANMELDUNG**

(43) Veröffentlichungstag:
**18.03.2009 Patentblatt 2009/12**

(51) Int Cl.:
***C23C 4/12*** *(2006.01)*          ***C23C 14/54*** *(2006.01)*
***C30B 23/02*** *(2006.01)*

(21) Anmeldenummer: **07116300.0**

(22) Anmeldetag: **13.09.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK RS**

(71) Anmelder: **Sulzer Metco AG**
**5610 Wohlen (CH)**

(72) Erfinder:
• **Heggemann, Dr., Marc**
**8405 Winterthur (CH)**

• **Barroso, Dr., Gabriel**
**8048 Zürich (CH)**
• **Muggli, Felix Andreas**
**8413 Neftenbach (CH)**
• **Waeger, Reto**
**5400 Baden (CH)**

(74) Vertreter: **Sulzer Management AG**
**Patentabteilung / 0067**
**Zürcherstrasse 12**
**8401 Winterthur (CH)**

(54) **Verfahren zur Bestimmung von Prozessparametern in einem plasmagestützten Prozess zur Oberflächenbehandlung**

(57)     Es wird ein Verfahren vorgeschlagen zur Bestimmung von Prozessparametern in einem plasmagestützten Prozess zur Oberflächenbehandlung, bei dem in einem Prozessraum ein Plasma generiert wird, mit dessen Hilfe eine Oberfläche modifiziert wird, bei welchem Verfahren für den plasmagestützten Prozess oder für den Prozessraum ein Betriebsmodell errichtet wird, mit dem eine Simulation des plasmagestützten Prozesses möglich ist, wobei das Betriebsmodell eine Methode aus der statistischen Mechanik umfasst, mit der mindestens ein Prozessparameter bestimmt wird.

Fig.1

EP 2 036 996 A1

**Beschreibung**

Die Erfindung betrifft ein Verfahren zur Bestimmung von Prozessparametern in einem plasmagestützten Prozess zur Oberflächenbehandlung gemäss dem Oberbegriff des unabhängigen Patentanspruchs.

Plasmagestützte Prozesse zur Oberflächenbehandlung finden in vielen industriellen Bereichen Anwendungen, beispielsweise bei physikalischen Abscheidungen aus der Dampfphase (PVD: physical vapor deposition), bei Plasmanitrierungen zur Oberflächenhärtung, bei Verfahren zum epitaktischen Wachstum durch Abscheidung aus der Gasphase oder bei Plasmaspritzprozessen zur Erzeugung von Beschichtungen auf Substraten.

Bei solchen Prozessen sind die zu erzielenden Oberflächenmodifikationen oft ganz unterschiedlicher Natur, sodass der Prozess üblicherweise an den jeweiligen Anwendungsfall angepasst werden muss. Meistens ist das zu erzielende Ergebnis vorgegeben, z. B. die speziellen Eigenschaften einer zu erzeugenden Beschichtung, und der Prozess muss möglichst optimal an dieses zu erzielende Ergebnis angepasst werden.

Daneben ist es insbesondere auch für industrielle Anwendungen sehr wichtig, dass der plasmagestützte Prozess an sich eine hohe Stabilität aufweist, also reproduzierbare Ergebnisse liefert, und dass er eine hohe Prozesseffizienz beinhaltet.

Um die plasmagestützten Prozesse unter diesen beispielhaft erwähnten Aspekten an die jeweilige Anwendung anzupassen, ist es wünschenswert wenn nicht sogar notwendig, Informationen über die Prozessparameter wie beispielsweise Gasgeschwindigkeit und -temperatur, Partikelgeschwindigkeit und Temperatur zu haben. Derartige Grössen sind zwar prinzipiell messtechnisch erfassbar, beispielsweise mit Hilfe von Hochgeschwindigkeitskameras, aber solche Messungen sind sehr aufwändig.

Auch im Hinblick auf die Weiter- oder Neuentwicklung oder die Optimierung von solchen plasmagestützten Prozessen zur Oberflächenbehandlung, die heute meist empirisch erfolgt, ist es wünschenswert, mehr Informationen über die Prozessparameter zu haben bzw. solche Informationen möglichst einfach zu erhalten.

In der europäischen Patentanmeldung Nr. 07102707.2 mit dem Titel "Verfahren zur Bestimmung von Prozessparametern in einem thermischen Spritzprozess" wird speziell für thermische Spritzprozesse ein Verfahren vorgeschlagen, bei welchem für den thermischen Spritzprozess oder für die thermische Spritzvorrichtung ein Betriebsmodell errichtet wird, mit dem eine Simulation des thermischen Spritzprozesses durchführbar ist, und welches ein strömungsmechanisches Modell sowie ein elektromagnetisches Modell umfasst, wobei das strömungsmechanische Modell und das elektromagnetische Modell miteinander gekoppelt werden.

Auch wenn sich dieses Verfahren in der Praxis bewährt hat, so gibt es bei Plasmaspritzprozessen und anderen plasmagestützten Prozessen zur Oberflächenbehandlung Plasmazustände, bei denen das genannte Verfahren nicht zu vollkommen befriedigenden Lösungen führt. Dies sind insbesondere Zustände, bei denen das Plasma eine hohe Temperatur hat und/oder bei einem niedrigen Prozessdruck generiert wird.

Hier will die Erfindung Abhilfe schaffen. Es ist daher eine Aufgabe der Erfindung, ein Verfahren vorzuschlagen, welches die Bestimmung von Prozessparametern in plasmagestützten Prozessen zur Oberflächenbehandlung insbesondere auch in solchen Fällen ermöglicht, wo das Plasma eine hohe Temperatur hat und/oder bei einem niedrigen Druck erzeugt wird.

Das diese Aufgabe lösende Verfahren ist durch die Merkmale des unabhängigen Anspruchs 1 gekennzeichnet.

Erfindungsgemäss wird also ein Verfahren vorgeschlagen zur Bestimmung von Prozessparametern in einem plasmagestützten Prozess zur Oberflächenbehandlung, bei dem in einem Prozessraum ein Plasma generiert wird, mit dessen Hilfe eine Oberfläche modifiziert wird, bei welchem Verfahren für den plasmagestützten Prozess oder für den Prozessraum ein Betriebsmodell errichtet wird, mit dem eine Simulation des plasmagestützten Prozesses möglich ist, dadurch gekennzeichnet, dass das Betriebsmodell eine Methode aus der statistischen Mechanik umfasst, mit der mindestens ein Prozessparameter bestimmt wird.

Dadurch, dass der plasmagestützte Prozess bzw. der Prozessraum durch ein Betriebsmodell beschrieben wird, dass auf einer Methode aus der statistischen Mechanik basiert, können die Prozessparameter auch für hohe Plasmatemperaturen und/oder niedrige Prozessdrücke bestimmt werden, ohne dass dafür eine messtechnische Erfassung des jeweiligen Betriebsparameters notwendig ist. Gerade in diesen Betriebsbereichen sind die Bedingungen für die Gültigkeit der Kontinuum-Modelle, makroskopischer Modelle wie beispielsweise basierend auf der Lösung der Navier-Stokes-Gleichungen, nicht mehr oder nicht mehr hinreichend gut erfüllt. Durch die erfindungsgemässe Anwendung einer mikroskopischen Methode basierend auf der statistischen Mechanik wird eine Simulation des plasmagestützten Prozesses und damit eine zuverlässige Bestimmung von Prozessparametern im Bereich niedriger Prozessdrücke und/oder hoher Plasmatemperaturen ermöglicht.

Dieses Betriebsmodell erlaubt es auch, Aussagen über die Prozessparameter in plasmagestützten Prozessen zu machen, wenn diese unter extremen Betriebsbedingungen arbeiten. Somit können beispielsweise Belastbarkeitsgrenzen für Plasmavorrichtungen untersucht werden.

Desweiteren ist das erfindungsgemässe Verfahren insbesondere für Weiter-und Neuentwicklungen sowie Optimierungen von plasmagestützten Prozessen zur Oberflächenbehandlung besonders vorteilhaft einsetzbar. Durch die erfindungsgemässe Bestimmung der Prozessparameter kann nämlich der gesamte Prozess bzw. der Prozessraum simuliert werden. Dies ermöglicht eine deutlich einfachere und schnellere Optimierung des Designs einer Vorrichtung oder Teilen davon.

Besonders bevorzugt ist die statistische Methode die Direct Simulation Monte Carlo (DSMC) Methode oder die Lattice-Boltzmann-Methode. Diese an sich bekannten Methoden haben sich als besonders geeignet erwiesen, um plasmagestützte Prozesse zur Oberflächenbehandlung effizient und mit ausreichender Genauigkeit zu simulieren.

Insbesondere eignet sich das erfindungsgemässe Verfahren auch, wenn in dem plasmagestützten Prozess Partikel aufgeschmolzen, verdampft oder aktiviert werden, um dann mittels des Betriebsmodells als Prozessparameter mindestens einen partikelspezifischen Parameter zu bestimmen. Ein typisches Anwendungsbeispiel für einen solchen Prozess ist ein thermischer Spritzprozess. Hier können mittels des erfindungsgemässen Verfahrens Parameter der in das Plasma eingebrachten Partikel bestimmt werden.

Dabei ist es insbesondere auch möglich, dass das Betriebsmodell die Wechselwirkung zwischen den Partikeln und dem Plasma umfasst. Durch die Berücksichtigung der in das Plasma eingebrachten Partikel im Betriebsmodell können die Prozessparameter noch genauer bestimmt werden. Zudem werden hierdurch Aussagen wie beispielsweise über die Flugbahn der Partikel oder ihre Geschwindigkeit und/oder ihre Temperatur - im speziellen beim Aufprall auf das Substrat - möglich.

Vorzugsweise wird bei solchen Prozessen, bei denen Partikel im Plasma aufgeschmolzen, verdampft oder aktiviert werden, zumindest einer der folgenden Prozessparameter bestimmt:

Geschwindigkeit der Partikel, Temperatur der Partikel an der Oberfläche der Partikel, Temperatur im Innern der Partikel, Aggregatzustand der Partikel, Spur der Partikel.

Das erfindungsgemässe Verfahren ist insbesondere geeignet, wenn der plasmagestützte Prozess ein thermischer Spritzprozess ist, bei welchem mittels des Plasmas Partikel aufgeschmolzen oder plastisch gemacht oder verdampft werden und von einem Fluidstrom zu einem Substrat transportiert werden, um auf dem Substrat eine Beschichtung zu erzeugen. Hier können mit dem erfindungsgemässen Verfahren insbesondere zuverlässige Aussagen über die Prozessparameter gemacht werden, wenn das Plasma sehr hohe Temperaturen aufweist und/oder bei niedrigen Prozessdrücken generiert wird.

Daher lässt sich das erfindungsgemässe Verfahren besonders vorteilhaft einsetzen, wenn der plasmagestützte Prozess ein LPPS Prozess (LPPS: Low Pressure Plasma Spraying) ist und speziell ein LPPS-Dünnfilm Prozess.

Weitere bevorzugte Einsatzmöglichkeiten für das erfindungsgemässe Verfahren sind es wenn der plasmamagestützte Prozess ein PVD-Prozess (PVD: Physical Vapor Deposition ) ist, oder wenn der plasmagestütze Prozess ein Aktivierungsprozess ist, insbesondere zur Nitrierung von Oberflächen, oder wenn der plasmagestützte Prozess ein Prozess für epitaktisches Wachstum durch Abscheidung aus der Gasphase ist.

Weitere vorteilhafte Massnahmen und bevorzugte Ausgestaltungen der Erfindung ergeben sich aus den abhängigen Ansprüchen.

Im Folgenden wird die Erfindung anhand von Ausführungsbeispielen und anhand der Zeichnung näher erläutert. In der schematischen Zeichnung zeigen:

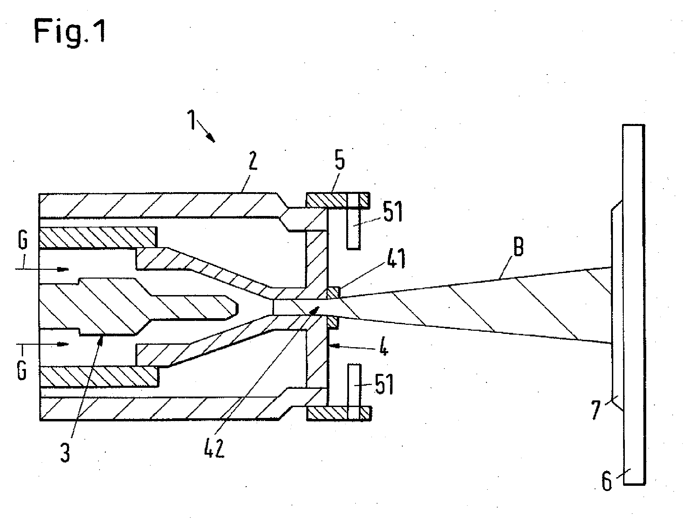

Fig. 1:    eine schematische Darstellung eines Ausführungsbeispiels einer Plasmaspritzvorrichtung.

Durch die Erfindung wird ein Verfahren zur Bestimmung von Prozessparametern in einem plasmagestützten Prozess vorgeschlagen, bei welchem in einem Prozessraum ein Plasma generiert wird, mit dessen Hilfe eine Oberfläche modifiziert wird. Mit der Modifizierung der Oberfläche sind alle möglichen Veränderungen einer Oberfläche gemeint wie beispielsweise das Aufbringen einer Beschichtung bzw. einer Schicht auf eine Oberfläche, das Aktivieren oder das Passivieren von Oberflächen, der Einbau von Atomen oder Molekülen in eine Oberfläche, das Herauslösen von Atomen, Molekülen oder sonstigen Teilchen aus einer Oberfläche, das epitaktische Kristallwachstum auf einer Oberfläche, Härtungs- oder Veredlungsbehandlungen von Oberflächen.

Mit dem Begriff "Prozessparameter" sind dabei alle Grössen gemeint, die in irgendeiner Form der Charakterisierung des plasmagestützten Prozesses, des Prozessraums oder des Betriebszustands der für den Prozess verwendeten Vorrichtung. Solche Prozessparameter sind beispielsweise: Geschwindigkeit oder Geschwindigkeitsfeld des Gases zur Generierung des Plasmas oder eines anderen Prozessgases oder -fluids, Temperatur bzw. Temperaturprofil des Fluids bzw. des Gases, Geschwindigkeit der Partikel (an verschiedenen Orten), wobei mit Partikel die Plasmateilchen gemeint sein können oder Teilchen bzw. Partikel, die in das Plasma eingetragen werden, Temperatur der Partikel an der Oberfläche oder im Innern der Partikel, Aggregatzustand der Partikel, Position bzw. Spur der Partikel, Desintegration oder Aufbrechen von Partikeln, Erosion, Kontaktpunkte zwischen einem Lichtbogen und den Elektroden, Form und Verlauf des Lichtbogens, charakteristische Eigenschaften des Fluids bzw. des Gases wie spezifische Wärmekapazität, Ionisationsgrad, spritzvorrichtungsspezifische Merkmale wie engster Düsenquerschnitt, Düsenaustrittsquerschnitt, Düsenlänge, geometrische Gestalt. Diese Aufzählung ist nicht abschliessend.

Im Folgenden wird zunächst einen für die Praxis besonders wichtigen Anwendungsfall Bezug genommen, nämlich, dass der plasmagestützte Prozess zur Oberflächenbehandlung ein thermischer Spritzprozess zur Erzeugung einer Beschichtung auf einem Substrat ist, der mit einer Plasmaspritzvorrichtung durchgeführt wird. Natürlich ist die Erfindung nicht auf solche Anwendungen beschränkt, wie weiter hinten noch erläutert wird. Beim thermischen Spritzprozess mittels Plasma werden Partikel in ein Plasma eingebracht dort aufgeschmolzen, verdampft oder plastisch gemacht und von einem Fluidstrom, beispielsweise einem Gasstrom zu einem Substrat transportiert.

Fig. 1 zeigt in einer stark schematischen Darstellung ein Ausführungsbeispiel einer Plasmaspritzvorrichtung, die gesamthaft mit dem Bezugszeichen 1 bezeichnet ist. Die Plasmaspritzvorrichtung 1 umfasst ein Gehäuse 2, in welchem eine Kathodenanordnung 3 und eine dagegen elektrisch isolierte Anode 4 vorgesehen ist. Die Anode 4 ist hier als Ringanode ausgestaltet, die in ihrem Zentrum eine Auslassöffnung 42 aufweist, die mit einer Düse 41 versehen ist. Während des Betriebs wird in axialer Richtung ein Gas durch die Plasmaspritzvorrichtung 1 geblasen wie dies durch die beiden mit dem Bezugszeichen G bezeichneten Pfeile angedeutet ist. In Strömungsrichtung gesehen hinter der ringförmigen Anode 4 ist eine Pulverzuführung 5 vorgesehen, die einen oder mehrere Zuführkanäle 51 aufweist, die sich im wesentliche in radialer Richtung erstrecken. Natürlich ist es auch möglich, dass sich die Zuführkanäle 51 für das Pulver bzw. die Partikel in axialer Richtung oder schräg - also zwischen axialer und radialer Richtungerstrecken.

Auf die Darstellung weiterer an sich bekannter Komponenten der Plasmaspritzvorrichtung 1 wie beispielsweise, Kühlung, Energieversorgung und Kontrolleinrichtungen wurde aus Gründen der besseren Übersicht verzichtet.

Die Plasmaspritzvorrichtung 1 kann insbesondere auch ein Mehrkathodenbrenner sein, wie beispielsweise der Brenner, der von der Anmelderin unter dem Handelsnamen TriplexPro vertrieben wird. Bei diesem Brenner umfasst die Kathodenanordnung 3 insgesamt drei Kathoden. Im Betriebszustand entstehen dann drei Lichtbögen.

Während des Betriebs wird das in axialer Richtung durch die Plasmaspritzvorrichtung 1 strömende Gas G ionisiert und es wird zwischen der Kathodenanordnung 3 und der Anode 4 mindestens ein Lichtbogen erzeugt. Das durch das Plasma erhitzte Gas G tritt mit hoher Geschwindigkeit und hoher Temperatur durch die Düse 41 aus der Anode aus. Direkt hinter der Anode 4 (in Strömungsrichtung des Gases gesehen) werden durch die Zuführkanäle 51 der Pulverzuführung 5 Partikel in Form eines Pulvers in den heissen Gasstrom eingeblasen. Die Partikel werden in dem Gasstrom aufgeschmolzen, verdampft oder zumindest plastisch gemacht , von dem Gasstrom beschleunigt und auf ein Substrat 6 geschleudert, wo sie eine Beschichtung 7 bilden. Der mit den Partikeln beladene Gasstrom ist in Fig.1 schematisch als Beschichtungsstrahl B dargestellt.

Im Speziellen ist das hier beschriebene Ausführungsbeispiel ein Plasmaspritzverfahren, welches gattungsgemäss in der WO-A-03/087422 oder auch in der US-A- 5 853 815 beschrieben ist. Dieses Plasmaspritzverfahren ist ein thermisches Spritzen zur Herstellung eines sogenannten LPPS-Dünnfilms (LPPS = Low Pressure Plasma Spraying). Mit dem LPPS-Dünnfilm-Prozess (LPPS-TF = LPPS Thin Film) wird ein konventionelles LPPS-Plasmaspritzverfahren verfahrenstechnisch abgewandelt, wobei ein von Plasma durchströmter Raum ("Plasmaflamme" oder "Plasmastrahl") aufgrund der Änderungen ausgeweitet und auf eine Länge von bis zu 2.5 m ausgedehnt wird. Die geometrische Ausdehnung des Plasmas führt zu einer gleichmässigen Aufweitung - einer "Defokussierung" - eines Pulverstrahls, der mit einem Fördergas in das Plasma injiziert wird. Das Material des Pulverstrahls, das im Plasma zu einer Wolke dispergiert und dort teilweise oder vollständig geschmolzen wird, gelangt gleichmässig verteilt auf eine weit ausgedehnte Oberfläche eines Substrats. Es entsteht auf dem Substrat eine dünne Lage, deren Schichtdicke kleiner als 10 $\mu$m sein kann und die dank der gleichmässigen Verteilung eine dichte Abdeckung bildet. Das LPPS-Verfahren wird üblicherweise bei niedrigen Prozessdrücken von weniger als 10 000 Pa und im Falle des LPPS-TF üblicherweise zwischen 10 Pa und 1000 Pa durchgeführt.

Häufig ist es im Anwendungsfall so, dass das zu erzielende Ergebnis - also die Beschichtung 7 auf dem Substrat 6 bzw. deren Eigenschaften vorgegeben sind und der thermische Spritzprozess so einzustellen ist, dass das gewünschte Ergebnis möglichst gut, effizient, kostengünstig und reproduzierbar realisiert wird. Hierfür ist es wichtig, Prozessparameter zu kennen.

Aus der bereits zitierten europäischen Patentanmeldung Nr. 07102707.2 ist ein Verfahren bekannt, um für einen thermischen Spritzprozess eine Simulation zur Bestimmung der Prozessparameter durchzuführen. Diese Simulation basiert auf einem Betriebsmodell, welches ein strömungsmechanisches Modell und ein damit gekoppeltes elektromagnetisches Modell umfasst.

Die strömungsmechanische Modellierung erfolgt gemäss der genannten europäischen Patentanmeldung vorzugsweise mittels numerischer Strömungssimulation (CFD - Computational Fluid Dynamics), die auf der Lösung der Navier-Stokes-Gleichungen basiert und daher ein Kontinuum-Modell darstellt.

Insbesondere im Falle hoher Temperaturen und/oder niedriger Prozessdrücke - wie also beispielsweise beim LPPS- bzw. LPPS-TF-Prozess wird nun erfindungsgemäss vorgeschlagen, den plasmagestützten Prozess bzw. den Prozessraum durch ein Betriebsmodell zu beschreiben, dass auf einer Methode aus der statistischen Mechanik basiert. Dem liegt die Erkenntnis zugrunde, dass die Modellierung mittels kontinuum-mechanischer Methoden insbesondere im Falle niedriger Prozessdrücke und/oder hoher Plasmatemperaturen nicht mehr adäquat ist, weil das Kontinuum verletzt wird.

Wenn die freie Weglänge der Gasteilchen (Atome oder Moleküle) oder anderer im Plasma befindlicher Partikel in die Grössenordnung charakteristischer Längen des Prozesses, also beispielsweise in die Grössenordnung der Abmessungen des Prozessraums kommt, befindet man sich näher im Bereich des sogenannten freien Molekularflusses (free molecular flow conditions) als im Bereich der Kontinuumsmechanik. In diesem nicht-Kontinuumsbereich ist es ähnlich wahrscheinlich oder wahrscheinlicher, dass ein Teilchen mit der Wand des Prozessraums oder der Plasmavorrichtung stösst, als dass es mit einem anderen Teilchen zusammenstösst.

Es hat sich gezeigt, dass hier die Boltzmann Gleichung als grundlegende Zustandsgleichung der kinetischen Gastheorie nicht mehr im Rahmen der Kontinuumsnäherung behandelt werden sollte. Deshalb wird erfindungsgemäss vorgeschlagen, ein Betriebsmodell zu erstellen, dass auf einer statistischen Methode bzw. auf einer statistischen Beschreibung des Prozesses basiert, welche also die statistische thermodynamische Verteilung der Teilchen berücksichtigt.

Quantitativ lässt sich in der Fluiddynamik der Übergang vom Bereich der Kontinuumsmechanik in den Bereich der statistischen Mechanik durch die Knudsen-Zahl $K_n$ erfassen, eine dimensionslose Grösse, die das Verhältnis aus mittlerer freier Weglänge der Moleküle oder Teilchen zu einer repräsentativen physikalischen Ausdehnung des Systems angibt. Die Knudsenzahl ist definiert als

$$K_n = \lambda / L = (k_B T) / (\sqrt{2} \pi \sigma^2 P L)$$

wobei $\lambda$ die mittlere freie Weglänge in Meter bezeichnet, L die repräsentative physikalische Ausdehnung des Systems in Meter, $k_B$ die Boltzmannkonstante $1.38 \times 10^{-23}$ J/K, T die absolute Temperatur in K, $\sigma$ den Teilchendurchmesser in Meter bzw. den Kollisionsdurchmesser der Teilchen in Meter.

Wenn die Knudsenzahl sehr viel kleiner als eins ist, so ist die freie Weglänge der Teilchen sehr klein gegen die physikalische Ausdehnung des Systems, man befindet sich im Bereich der Kontinuumsmechanik, wo die Lösung der Navier-Stokes-Gleichungen eine sehr gute Modellierung des Systems liefert. Ist die Knudsenzahl in der Nähe oder grösser als eins, so ist die mittlere freie Weglänge der Teilchen vergleichbar oder sogar gross gegen die physikalische Ausdehnung des Systems, d.h. die einzelnen Teilchen stossen eher gegen die Wändes des Systems als dass es zu Stössen zwischen den Teilchen kommt. Die Kontinuumsannahme der Fluidmechanik liefert keine gute Näherung mehr für die Beschreibung des Systems.

Erfindungsgemäss wird daher vorgeschlagen, zur Bestimmung von Prozessparametern in einem plasmagestützten Prozess zur Oberflächenbehandlung mittels statistischer Methoden ein Betriebsmodell zu erstellen, mit dem eine Simulation des plasmagestützten Prozesses möglich ist und das die Bestimmung des oder der Prozessparameter ermöglicht. Im Unterschied zu Kontinuum-Modellen werden hier diskrete Teilchen betrachtet bzw. berechnet, die aber nicht unbedingt mit real existierenden Teilchen übereinstimmen müssen. Alternativ werden die zeitliche Entwicklung der lokalen Verteilungsdichtefunktion auf den Gitterknoten des Rechengitters z. B. durch eine linearisierte Boltzmann-Gleichung berechnet.

Da somit eine messtechnische Erfassung der Prozessparameter nicht mehr notwendig ist, sondern der plasmagestützte Prozess simuliert werden kann, ist der Prozess bzw. die dafür verwendete Vorrichtung nun auch in solchen Betriebszuständen analysierbar, die bisher noch nicht untersucht worden sind. Zudem ist es möglich, Prozessparameter zu bestimmen, die bisher messtechnisch nur sehr schwierig oder gar nicht ermittelt werden konnten,

Besonders bevorzugt wird zur Erstellung des Betriebsmodells und damit zur Bestimmung des oder der Prozessparameter die Direct Simulation Monte Carlo (DSMC) Methode eingesetzt. Die DSMC und ihre Grundlagen an sich sind dem Fachmann bekannt und brauchen daher hier nicht näher erläutert zu werden.

Bei der DSMC Methode ist eine auf Wahrscheinlichkeitstheorie basierte Simulation, mit welcher Lösungen für die Boltzmann-Gleichung für Fluidströme zumindest approximativ ermittelt werden können. Mit der DSMC Methode lassen sich im Allgemeinen Fluidströmungen modellieren, wobei repräsentative Moleküle oder Teilchen betrachtet werden, von denen jedes repräsentativ für eine Vielzahl real existierender Teilchen oder Moleküle ist. Mit diesen repräsentativen Teilchen werden auf Wahrscheinlichkeitsrechnungen basierte Simulationen durchgeführt, um Lösungen für die Boltzmanngleichungen zu finden. Die repräsentativen Teilchen werden mittels Simulation in realistischer Weise durch den physikalischen Raum bewegt. Dabei werden Stösse zwischen den Teilchen und Stösse der Teilchen mit den Begrenzungen des physikalischen Raums mit Hilfe von Wahrscheinlichkeitsaussagen und von phänomenologischen bzw. empirischen Modellen in die Modellierung einbezogen.

Bei vielen Plasmaprozessen wie beispielsweise dem thermischen Spritzen, werden Partikel als disperse Phase in den Fluidstrom bzw. in das Plasma eingebracht . Es ist möglich, aber nicht in allen Fällen notwendig, die disperse Phase bei der DSMC in das Modell einzubeziehen. Das heisst, die Partikel müssen nicht zwangsläufig bei der DSMC berücksichtigt werden. Vorzugsweise umfasst das Betriebsmodell jedoch auch die Partikel und die Wechselwirkung zwischen den Partikeln und dem Gas- oder Fluidstrom.

Es gibt zahlreiche an sich bekannte und kommerziell erhältliche Computerprogrammprodukte und Algorithmen für die DSMC Methode, die dem Fachmann hinreichend bekannt sind, sodass hierauf nicht weiter eingegangen wird.

Bei der Modellierung wird zunächst der zu berechnende Prozessraum als dreidimensionaler Volumenkörper definiert, beispielsweise mittels eines CAD-Modells. Der Prozessraum kann dabei beispielsweise der Plasmabrenner einer thermischen Spritzvorrichtuing sein, oder eine Prozesskammer in welcher ein PVD-Prozess oder eine Nitrierbehandlung durchgeführt wird, oder sonst ein beliebiger physikalischer Raum, in welchem das Plasma generiert oder der Plasmaprozess durchgeführt wird. Es werden dann die repräsentativen Modellteilchen festgelegt, von denen jedes repräsentativ für eine grosse Zahl - beispielsweise $10^9$ - real existierender Teilchen wie Moleküle, Atome oder andere Partikel ist. Die repräsentativen Teilchen entsprechen Probeteilchen, die aus der Boltzmann-Verteilungsfunktion bestimmt werden. Für diese repräsentativen Teilchen werden Randbedingungen festgelegt, welche die physikalischen Betriebsbedingungen definieren, beispielsweise Massenströme oder Flussrate beim Eintritt, Temperatur Anzahl und Geschwindigkeit der Teilchen beim Eintritt in den Prozessraum, Temperatur an den Wänden, Stromstärke oder ähnliches. Nun werden mit an sich bekannten numerischen Prozeduren der DSMC an den diskreten repräsentativen Teilchen Rechnungen durchgeführt, aus denen sich dann Prozessparameter, wie beispielsweise makroskopische Grössen ableiten lassen. Für die Wechselwirkung der repräsentativen Teilchen untereinander bzw. mit den Wänden des Prozessraums werden Kollisionsmodelle verwendet, die auf der Boltzmann-Zustandsgleichung beruhen. Auf diese Weise lässt sich anhand der Berechnungen an den diskreten repräsentativen Teilchen mittels der DSMC Methode der plasmagestütze Prozess vollständig simulieren.

Je nach Art des plasmagestützten Prozesses kann es vorteilhaft sein, die elektromagnetischen Kopplungen bzw. Wechselwirkungen bei der Modellierung zu berücksichtigen. Beim Plasmaspritzen beispielsweise kann durch die Kopplung mit einem elektromagnetischen Modell der zwischen Anode und Kathode befindliche Lichtbogen oder die Lichtbögen beschrieben werden. Der Lichtbogen bzw. das Plasma verursachen wiederum elektromagnetische Effekte wie elektrische Potentiale, magnetische Felder usw., deren Einfluss durch ein elektromagnetische Modell bzw. seine Kopplung mit der DSMC Methode berücksichtigt werden können.

Das elektromagnetische Modell basiert auf den Maxwell-Gleichungen sowie den Materialeigenschaften für die Polarisation (Dielektrizitätskonstante), die Magnetisierung (Permeabilität) und die Leitfähigkeit.

Mit Hilfe des Betriebsmodells ist eine vollständige Simulation des plasmagestützten Prozesses möglich. Das heisst insbesondere, dass jeder Prozessparameter mittels des Betriebsmodells bestimmt werden kann.

Dadurch, dass durch das Betriebsmodell der gesamte plasmagestützte Prozess simuliert werden kann, wird es möglich, den Prozess bzw. die dafür verwendete Vorrichtung wesentlich schneller und effizienter an den jeweiligen Anwendungsfall anzupassen bzw. für den jeweiligen Anwendungsfall zu optimieren. Dies ist insbesondere im Hinblick auf die Neu- und Weiterentwicklung von Prozessen und Vorrichtungen ein wichtiger Vorteil. Es sind nämlich für die Anpassung und Optimierung keine zeit- und kostenintensiven Versuchsreihen mehr notwendig, in welchen empirisch motivierte Modifikationen getestet werden, sondern der Einfluss von Änderungen auf die Prozessparameter kann anhand des Betriebsmodells ohne experimentellen Aufwand untersucht werden.

Für industrielle Anwendungen ist insbesondere die Stabilität des Prozesses von grosser Bedeutung, das heisst, über einen längeren Zeitraum soll immer wieder die gleichen Ergebnisse mit den gleichen Eigenschaften erzeugt werden. Hier kann das erfindungsgemässe Verfahren dazu genutzt werden, die für die Prozessstabilität wesentlichen Prozessgrössen zu identifizieren und den Einfluss ihrer betriebsbedingten Schwankungen zu analysieren.

Da die Effizienz des Prozesses unter wirtschaftlichen Aspekten eine wesentliche Rolle spielt, besteht das Bestreben, solche plasmagestützten Prozesse an der Grenze ihrer Belastbarkeit zu betreiben. Hier eignet sich das erfindungsgemässe Verfahren, diese Grenzen genauer zu bestimmen.

Auch im Hinblick auf Neu- und Weiterentwicklungen von Vorrichtungen für plasmagestütze Oberflächenmodifikationen bildet das erfindungsgemässe Verfahren ein sehr nützliches Werkzeug zur Optimierung des Designs.

Neben der DSMC Methode eignen sich auch andere statistische Methoden für das erfindungsgemässe Verfahren. Als ein weiteres Verfahren sei hier die Lattice-Boltzmann-Methode genannt. Auch diese eignet sich als statistische Methode für die Errichtung des Betriebsmodells in dem erfindungsgemässen Verfahren. Bei den Lattice-Boltzmann-Berechnungen wird das System bzw. die Fluidströmung durch eine linearisierte Boltzmann-Gleichung beschrieben, Anstelle von diskreten repräsentativen Teilchen werden Teilchendichte-Verteilungsfunktionen berechnet. Im Unterschied zur DSMC Methode, wo sich die repräsentativen Teilchen unabhängig vom Rechengitter überall im Raum befinden können, werden bei der Lattice-Boltzmann -Methode die Teilchendichte-Verteilungsfunktionen an den Gitterknotenpunkten betrachtet.. Derartige Berechnungen bzw. numerische Verfahren sind dem Fachmann hinreichend bekannt und brauchen daher nicht weiter erläutert zu werden.

Natürlich ist das erfindungsgemässe Verfahren nicht auf plasmagestützte Spritzprozesse beschränkt, sondern eignet sich allgemein für plasmagestützte Prozesse zur Oberflächenmodifikation. Dabei kann es sich um solche Prozesse handeln, bei denen das Plasma direkt oder indirekt dazu genutzt wird, Partikel aufzuschmelzen, zu plastifizieren oder zu verdampfen, oder um solche Prozesse, bei denen das Plasma für Aktivierungsprozesse eingesetzt wird., beispielsweise das Aufbrechen von molekularem Stickstoff in atomaren Stickstoff, das Ionisieren von Molekülen oder Atomen, das Reinigen oder Aktivieren von Oberflächen.

Insbesondere eignet sich das erfindungsgemässe Verfahren auch für plasmagestützte PVD-Prozesse (PVD: Physical Vapor Deposition), für plasmagestützte Oberflächenbehandlungen, bei denen in die oberflächennahen Bereiche eines Substrats Atome oder Moleküle eingebaut werden, um die Eigenschaften der Oberfläche gezielt zu modifizieren. Als Beispiel hierfür sei das Plasmanitrieren genannt, bei welchem zur Oberflächenhärtung atomarer Stickstoff in die oberflächennahen Bereiche eines Substrats eingebracht wird.

Das erfindungsgemässe Verfahren eignet sich insbesondere auch für plasmagestützte Prozesse für epitaktisches Wachstum durch Abscheidung aus der Gasphase. Ein solcher Prozess bzw. eine Vorrichtung hierfür wird beispielsweise in der WO-A-2006/097804 beschrieben. Hier wird ein Plasma zur epitaktischen Abscheidung von Halbleiterschichten verwendet. In eine Prozesskammer wird ein Metalldampf (ein oder mehrere Metalle) mit einem nicht metallischen Element gemischt. Das Gas wird durch ein dichtes niederenergetisches Plasma aktiviert, reagiert mit dem Metalldampf und scheidet sich dann als Halbleiterschicht epitaktisch auf dem Substrat ab. Auch dieser prozess kann mit dem erfindungsgemässen Verfahren simuliert werden.

Das erfindungsgemässe Verfahren ist vorzugsweise in Form eines Computerprogrammprodukts in einer Datenverarbeitungsanlage implementiert.

**Patentansprüche**

1. Verfahren zur Bestimmung von Prozessparametern in einem plasmagestützten Prozess zur Oberflächenbehandlung, bei dem in einem Prozessraum ein Plasma generiert wird, mit dessen Hilfe eine Oberfläche modifiziert wird, bei welchem Verfahren für den plasmagestützten Prozess oder für den Prozessraum ein Betriebsmodell errichtet wird, mit dem eine Simulation des plasmagestützten Prozesses möglich ist, **dadurch gekennzeichnet, dass** das Betriebsmodell eine Methode aus der statistischen Mechanik umfasst, mit der mindestens ein Prozessparameter bestimmt wird.

2. Verfahren nach Anspruch 1, bei welchem die Methode aus der statistischen Mechanik die Direct Simulation Monte Carlo (DSMC) Methode oder die Lattice-Boltzmann-Methode ist.

3. Verfahren nach einem der vorangehenden Ansprüche, wobei in dem plasmagestützten Prozess Partikel aufgeschmolzen, verdampft oder aktiviert werden, und wobei mittels des Betriebsmodells als Prozessparameter mindestens ein partikelspezifischer Parameter bestimmt wird.

4. Verfahren nach Anspruch 3 bei welchem das Betriebsmodell die Wechselwirkung zwischen den Partikeln und dem Plasma umfasst.

5. Verfahren nach einem Ansprüche 3 oder 4, bei welchem zumindest einer der folgenden Prozessparameter bestimmt wird:

   Geschwindigkeit der Partikel, Temperatur der Partikel an der Oberfläche der Partikel, Temperatur im Innern der Partikel, Aggregatzustand der Partikel, Spur der Partikel.

6. Verfahren nach einem der vorangehenden Ansprüche, bei welchem der plasmagestützte Prozess ein thermischer Spritzprozess ist, bei welchem mittels des Plasmas Partikel aufgeschmolzen oder plastisch gemacht oder verdampft werden und von einem Fluidstrom zu einem Substrat transportiert werden, um auf dem Substrat eine Beschichtung zu erzeugen.

7. Verfahren nach einem der vorangehenden Ansprüche, bei welchem der plasmagestützte Prozess ein LPPS Prozess (LPPS: Low Pressure Plasma Spraying) ist und speziell ein LPPS-Dünnfilm Prozess.

8. Verfahren nach einem der vorangehenden Ansprüche, bei welchem der plasmamagestützte Prozess ein PVD-Prozess (PVD: Physical Vapor Deposition ) ist.

9. Verfahren nach einem der vorangehenden Ansprüche. Bei welchem der plasmagestütze Prozess ein Aktivierungsprozess ist, insbesondere zur Nitrierung von Oberflächen.

10. Verfahren nach einem der vorangehenden Ansprüche, bei welchem der plasmagestützte Prozess ein Prozess für epitaktisches Wachstum durch Abscheidung aus der Gasphase ist.

Fig.1

**Europäisches
Patentamt**

**EUROPÄISCHER RECHERCHENBERICHT**

Nummer der Anmeldung

EP 07 11 6300

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | ZHANG T ET AL: "Statistical Analysis of the Motion and Heating of Particles in a Plasma Jet" PLASMA CHEMISTRY AND PLASMA PROCESSING, KLUWER ACADEMIC PUBLISHERS-PLENUM PUBLISHERS, NE, Bd. 25, Nr. 4, 1. August 2005 (2005-08-01), Seiten 403-425, XP019290281 ISSN: 1572-8986 * Seiten 404-405 * * Seiten 408-413 * * Seite 424 * ----- | 1-7 | INV. C23C4/12 C23C14/54 C30B23/02 |
| X | ZHANG ET AL: "Computer model to simulate the random behaviour of particles in a thermal-spray jet" SURFACE AND COATINGS TECHNOLOGY, ELSEVIER, AMSTERDAM, NL, Bd. 201, Nr. 6, 17. November 2006 (2006-11-17), Seiten 3552-3563, XP005729323 ISSN: 0257-8972 * Seite 3552 - Seite 3553 * * Seite 3561 - Seite 3562 * ----- | 1-7 | |
| X | ZHANG ET AL: "Simulation of powder transport in plasma jet via hybrid Lattice Boltzmann method and probabilistic algorithm" SURFACE AND COATINGS TECHNOLOGY, ELSEVIER, AMSTERDAM, NL, Bd. 201, Nr. 3-4, 5. Oktober 2006 (2006-10-05), Seiten 886-894, XP005646872 ISSN: 0257-8972 * das ganze Dokument * ----- -/-- | 1-3,5-7 | RECHERCHIERTE SACHGEBIETE (IPC) C23C |

Der vorliegende Recherchenbericht wurde für alle Patentansprüche erstellt

| Recherchenort | Abschlußdatum der Recherche | Prüfer |
|---|---|---|
| Den Haag | 21. Januar 2008 | Chalaftris, Georgios |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

..............................................................................
& : Mitglied der gleichen Patentfamilie, übereinstimmendes Dokument

EPO FORM 1503 03.82 (P04C03)

**Europäisches Patentamt**

**EUROPÄISCHER RECHERCHENBERICHT**

Nummer der Anmeldung

EP 07 11 6300

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 4 800 100 A (HERBOTS NICOLE [US] ET AL) 24. Januar 1989 (1989-01-24) * Spalte 4, Zeile 37 - Zeile 51 * * Spalte 6, Zeile 41 - Zeile 46 * * Spalte 12, Zeile 5 - Zeile 11 * * Spalte 14, Zeile 53 - Spalte 15, Zeile 23; Anspruch 12 * * Spalte 23, Zeile 13 - Zeile 39 * ----- | 1,2,10 | |
| X | US 2004/074771 A1 (FAN QI HUA [US] ET AL) 22. April 2004 (2004-04-22) * Absätze [0016] - [0018], [0022], [0023], [0063] - [0065] * ----- | 1,2,8 | |
| X | LIU ET AL: "Monte Carlo simulation of nitriding in iron by a mixing technology with laser and plasma beams" CURRENT APPLIED PHYSICS, NORTH-HOLLAND, Bd. 7, Nr. 6, 29. Juni 2007 (2007-06-29), Seiten 683-689, XP022134722 ISSN: 1567-1739 * das ganze Dokument * ----- | 1,2,9 | RECHERCHIERTE SACHGEBIETE (IPC) |
| X | JACOBS W ET AL: "Determination of Ti+-flux and Ar+-flux of ionized physical vapor deposition of titanium from multiscale model calibration with test structures" JOURNAL OF VACUUM SCIENCE AND TECHNOLOGY A. VACUUM, SURFACES AND FILMS, AMERICAN INSTITUTE OF PHYSICS, NEW YORK, NY, US, Bd. 21, Nr. 4, Juli 2003 (2003-07), Seiten 922-936, XP012006493 ISSN: 0734-2101 * Seite 922 - Seite 923 * * Seite 927 - Seite 928 * ----- -/-- | 1-3,5,8 | |

Der vorliegende Recherchenbericht wurde für alle Patentansprüche erstellt

| Recherchenort | Abschlußdatum der Recherche | Prüfer |
|---|---|---|
| Den Haag | 21. Januar 2008 | Chalaftris, Georgios |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**Europäisches Patentamt**

# EUROPÄISCHER RECHERCHENBERICHT

Nummer der Anmeldung

EP 07 11 6300

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | VYAS VIVEK ET AL: "Scaling of hollow cathode magnetrons for ionized metal physical vapor deposition" JOURNAL OF VACUUM SCIENCE AND TECHNOLOGY A. VACUUM, SURFACES AND FILMS, AMERICAN INSTITUTE OF PHYSICS, NEW YORK, NY, US, Bd. 24, Nr. 5, 6. September 2006 (2006-09-06), Seiten 1955-1969, XP012091203 ISSN: 0734-2101 * Seite 1955 - Seite 1956 * * Seite 1968 * | 1-5,8 | |
| A | * Seite 1955 * * Seite 1968 *  ----- | 7 | |
| | | | **RECHERCHIERTE SACHGEBIETE (IPC)** |

Der vorliegende Recherchenbericht wurde für alle Patentansprüche erstellt

| Recherchenort | Abschlußdatum der Recherche | Prüfer |
|---|---|---|
| Den Haag | 21. Januar 2008 | Chalaftris, Georgios |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

......................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 07 11 6300

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

21-01-2008

| Im Recherchenbericht angeführtes Patentdokument | Datum der Veröffentlichung | Mitglied(er) der Patentfamilie | Datum der Veröffentlichung |
|---|---|---|---|
| US 4800100 A | 24-01-1989 | KEINE | |
| US 2004074771 A1 | 22-04-2004 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 07102707 A
- WO 03087422 A
- US 5853815 A
- WO 2006097804 A